# EUROPEAN PATENT APPLICATION

(11) **EP 4 382 996 A1**
(43) Date of publication of application: **12.06.2024**
(21) Application number: 23742940.2
(22) Date of filing: 18.01.2023
(51) Int. Cl.: G02B 30/56, C23C 14/35, C23C 14/16, C23C 14/18, C03C 3/085, C03B 18/02, C03B 25/00, C03C 17/36

(54) **MICRO-CHANNEL MATRIX OPTICAL WAVEGUIDE FLAT PLATE AND PREPARATION METHOD THEREFOR**

(30) Priority: 19.01.2022 CN 202210060077
(71) Applicant: Xianghang (Rudong) Technology Co., Ltd, Nantong, Jiangsu 226000 (CN); Xianghang (Shanghai) Technology Co., Ltd., Shanghai 200040 (CN)
(72) Inventor: WANG, Kan, Shanghai 200040 (CN); HAO, Yaqi, Nantong, Jiangsu 226000 (CN); ZHANG, Bing, Nantong, Jiangsu 226000 (CN)
(74) Representative: Viering, Jentschura & Partner mbB Patent- und Rechtsanwälte
(86) International application number: PCT/CN2023/072931
(87) International publication number: WO 2023/138625

(57) **Abstract**

The present invention provides a microchannel matrix optical waveguide plate, which is formed by stacking two optical element groups perpendicularly. Each of the optical element groups is composed of a plurality of parallel-arranged optical elements. Each of the optical elements includes a glass substrate. The glass substrate is divided into an air surface and a reflecting surface. A first metal film layer, a magnetic material film layer and a second metal film layer are sequentially arranged on the air surface. The present invention uses magnetic material attraction to replace an adhesive to achieve tight fitting of optical elements, thus reducing the influence of the adhesive on reflected light of optical elements. The fabricated microchannel matrix optical waveguide plate has the characteristics of high imaging definition and simple fabrication process.

## Description

### TECHNICAL FIELD

The present invention relates to the technical field of medium-free aerial imaging, and specifically relates to a microchannel matrix optical waveguide plate and a method for fabricating the same.

### BACKGROUND

Medium-free aerial imaging technology mainly uses a microchannel matrix optical waveguide plate, which is achieved through two reflections of an optical path by two layers of transparent materials arranged orthogonally, and then re-convergence in the air. It can reflect point light sources, line light sources, and surface light sources, but after being converged in the air, they are still point light sources, line light sources, and surface light sources. This special optical path reflection effect has led to the practical application of aerial imaging technology. However, the resolution and definition of aerial imaging using the microchannel matrix optical waveguide plate achieved by adopting two layers of orthogonally arranged transparent materials are not enough, which not only affects user experience but also puts higher requirements on application scenarios, resulting in great constraints on the commercial promotion and large-scale application of medium-free aerial imaging technology.

Medium-free aerial imaging technology replicates a light field through an optical micro mirror structure and reproduces a 3D real image in a 3D space. The optical micro mirror structure records the intensity, angle, wavelength, and other information of each light beam from a physical light source in an "object space" towards a light plate, and replicates light beams that are completely mirrored with the recorded light beams in the "image space" on the other side of the array. These replicated light beams form a real image that is completely mirrored with an object in the "object space" at a symmetrical position in the "image space" through a refocusing process. The microchannel matrix optical waveguide plate is called optical crystallite structure. The existing method for fabricating the microchannel matrix optical waveguide plate is to firstly cut a glass plate into several strips, then bond the glass strips in parallel into a transparent stack, and then bond two transparent stacks to form a whole optical imaging element. However, in a case that adhesive bonding is used to achieve splicing, since adhesive and glass are different media, when the optical path is obliquely projected from one medium into another, it will inevitably cause a change in the propagation direction, forming a refraction phenomenon, which will affect the reflection path of the optical path and thus affect the aerial imaging effect.

### SUMMARY

Aiming at solving the problems in the prior art, the present invention provides a microchannel matrix optical waveguide plate and a method for fabricating the same, which uses magnetic material attraction to replace an adhesive to achieve tight fitting of optical elements, thus reducing the influence of the adhesive on reflected light of optical elements. The fabricated microchannel matrix optical waveguide plate has the characteristics of high imaging definition and simple fabrication process.

The present invention adopts the following technical solutions:
The present invention proposes a microchannel matrix optical waveguide plate. The microchannel matrix optical waveguide plate is formed by stacking two optical element groups perpendicularly. Each of the optical element groups is composed of a plurality of parallel-arranged optical elements. Each of the optical elements includes a glass substrate. The glass substrate is divided into an air surface and a reflecting surface. A first metal film layer, a magnetic material film layer and a second metal film layer being sequentially arranged on the air surface.

The present invention further provides a method for preparing the microchannel matrix optical waveguide plate described above, which is the microchannel matrix optical waveguide plate according to claim 1, the method including:
S1: ultrasonically cleaning the glass substrate with acetone for 5-10 min, then cleaning the glass substrate with ethanol for 5-10 min, blow-drying the glass substrate with nitrogen gas, and then putting the glass substrate into a magnetron sputtering coating machine;
S2: vacuumizing a working chamber of the coating machine to achieve a vacuum degree of 1.0*10⁻³-5*10⁻³ Pa, and increasing temperature to 100-150°C;
S3: performing magnetron sputtering deposition on the air surface of the glass substrate by using a first metal target to obtain the first metal film layer with a deposition thickness of 0.05-0.2 um;
S4: performing magnetron sputtering deposition on the first metal film layer by using a magnetic target to obtain the magnetic material film layer with a deposition thickness of 0.1-50 um;
S5: performing magnetron sputtering deposition on the magnetic material film layer by using a second metal target to obtain a second metal film layer with a deposition thickness of 0.05-0.2 um to obtain a glass element;
S6: cutting the glass element obtained in S5 by using a carbon dioxide laser cutting machine to obtain glass strips with a width of 0. 1-0.3 mm and a length of 100-600 mm;
S7: ultrasonically cleaning the glass strips to obtain the optical elements;
S8: placing a plurality of optical elements in parallel with reflecting surfaces facing a same direction, placing and tightly clamping the optical elements in a special fixture, and then polishing the optical elements by using a double-sided polishing disc to obtain an optical element group; and
S9: obtaining two optical element groups through S1 to S8, stacking the two optical element groups with the reflecting surfaces of the two optical element groups being perpendicular to each other, and bonding the two optical element groups by using a high-transmittance adhesive to obtain the microchannel matrix optical waveguide plate.

In the present invention, in S1, a method for preparing the glass substrate includes:
step 1: proportioning: preparing a glass raw material by using the following components: 70%-85% of silica sand, 10%-20% of kaolin, 5%-10% of calcite and 1%-5% of dolomite, and putting the glass raw material into a grinder for grinding till a particle size is 600-mesh to 800-mesh;
step 2: melting: putting the glass raw material obtained through the grinding in step 1 into a tank furnace filled with nitrogen gas and hydrogen gas for melting at a melting temperature of 1,200-1,800°C to obtain molten glass;
step 3: formation: after the molten glass obtained through the melting in step 2 is cooled to 1,000°C or less, feeding the molten glass into a tin bath filled with inert gas, and standing for cooling for 1-3 h to obtain a flat glass belt; and
step 4: annealing: moving the glass belt obtained in step 3 into an annealing furnace for annealing at an annealing temperature within a range of 550-750°C.

In the present invention, in S3, parameters for the magnetron sputtering deposition of the first metal film layer are as follows: Al target thickness: 5-10 mm, magnetic field intensity: 50-100 Gs, Al target power: 80-150 W, sputtering pressure: 0.5-1.5 Pa, Ar: 100-250 mL/min, deposition temperature: 100-150°C, and sputtering deposition time: 5-10 min.

In the present invention, in S4, parameters for the magnetron sputtering deposition of the magnetic material film layer are as follows: magnetic target thickness: 2-3 mm, magnetic field intensity: 600-900 Gs, magnetic target power: 2-5 Kw, sputtering pressure: 1.5-2.5 Pa, Ar: 200-400 mL/min, deposition temperature: 100-120°C, and sputtering deposition time: 10-20 min.

In the present invention, in S4, the magnetic target is one of ferrite, aluminum-nickel-cobalt alloy, samarium-cobalt alloy, neodymium-iron-boron alloy, and iron-chromium-cobalt alloy.

In the present invention, in S5, parameters for the magnetron sputtering deposition of the second metal film layer are as follows: Al target thickness: 5-10 mm, magnetic field intensity: 100-200 Gs, Al target power: 3-9 Kw, sputtering pressure: 0.5-1.5 Pa, Ar: 100-250 mL/min, deposition temperature: 100-120°C, and sputtering deposition time: 10-20 min.

In the present invention, the first metal target in S3 and the second metal target in S5 are one of Ti, Sn, Cr, Al, or Ag.

In the present invention, in S9, the high-transmittance adhesive includes the following raw material components in parts by weight: 60-80 parts of aliphatic polyurethane acrylate, 15-25 parts of acrylate monomer, 0.1-0.5 parts of hexanediol, 2-8 parts of isoborneol acrylate, 1-10 parts of a photoinitiator, 0.01-0.5 parts of a leveling agent, and 0.1-1 part of a defoaming agent.

The present invention has the following beneficial technical effects:
(1) The present invention uses magnetic material attraction to replace an adhesive to achieve tight fitting of optical elements, thus not only reducing the influence of the adhesive on reflected light of optical elements, but also improving the imaging definition of the microchannel matrix optical waveguide plate, eliminating the adhesive bonding step, greatly simplifying the fabrication process and improving the production efficiency.
(2) The air surface of the optical element of the present invention is deposited with the first metal film layer, the magnetic material film layer, and the second metal film layer, which can reflect all the light entering the optical element, thus ensuring that the light can converge in the air after being reconstructed through the light field, and achieving aerial imaging.
(3) The high-transmittance adhesive of the present invention is prepared through photopolymerization reaction between acrylate monomer and aliphatic polyurethane acrylate under the action of a photoinitiator. The prepared adhesive not only has high bonding strength with glass, but also has high transmittance, thus effectively reducing the reflection phenomenon of light entering the adhesive.

### BRIEF DESCRIPTION OF THE DRAWINGS

FIG. 1 illustrates a schematic structural diagram of a microchannel matrix optical waveguide plate according to the present invention.
FIG. 2 illustrates a schematic structural diagram of an optical element according to the present invention.

Description of reference numerals: 1-optical element, 2-glass substrate, 3-first metal film layer, 4-magnetic material film layer, and 5-second metal film layer.

### DETAILED DESCRIPTION

The present invention will be specifically described below in combination with the embodiments with reference to the accompanying drawings. Obviously, the described embodiments are only a part of the embodiments of the present invention, not all of them. All other embodiments obtained by those skilled in the art based on the embodiments of the present invention without creative efforts still fall within the scope of protection of the present invention.

A microchannel matrix optical waveguide plate and a method for fabricating the same provided in the present invention will be described in detail in combination with the specific preferred embodiments.

### Embodiment 1

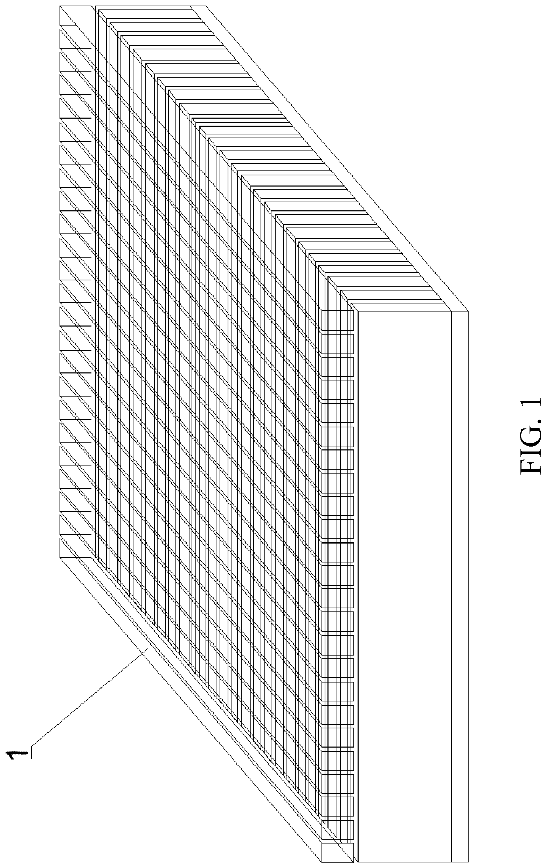

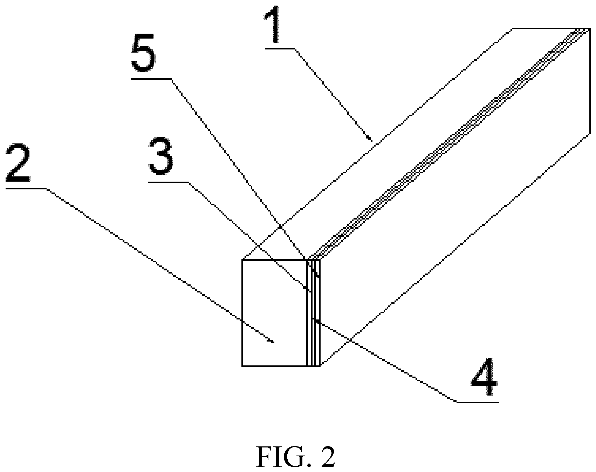

Referring to FIG. 1 and FIG. 2, this embodiment provides a microchannel matrix optical waveguide plate. The microchannel matrix optical waveguide plate is formed by stacking two optical element groups perpendicularly. Each of the optical element groups is composed of a plurality of parallel-arranged optical elements 1. Each of the optical elements 1 includes a glass substrate 2. The glass substrate 2 is divided into an air surface and a reflecting surface. A first metal film layer 3, a magnetic material film layer 4 and a second metal film layer 5 are sequentially arranged on the air surface.

A method for fabricating the microchannel matrix optical waveguide plate includes the following steps:
In S1, a glass substrate 2 is ultrasonically cleaned with acetone for 10 min, then is cleaned with ethanol for 5 min, blow-dried with nitrogen gas, and then put into a magnetron sputtering coating machine.

In S2, a working chamber of the coating machine is vacuumized to achieve a vacuum degree of 1.0*10⁻³ Pa, and temperature is increased to 150°C.

In S3, an Al film layer is deposited on an air surface of the glass substrate. Parameters for magnetron sputtering deposition are as follows: Al target thickness: 5 mm, magnetic field intensity: 50 Gs, Al target power: 80 W, sputtering pressure: 1.5 Pa, Ar: 100 mL/min, deposition temperature: 150°C, sputtering deposition time: 10 min, and deposition thickness: 0.2 um.

In S4, a Fe₃O₄ magnetic material film layer is deposited on the first metal film layer. Parameters for magnetron sputtering are as follows: Fe₃O₄ target thickness: 2 mm, magnetic field intensity: 900 Gs, magnetic target power: 2 Kw, sputtering pressure: 2.5 Pa, Ar: 200 mL/min, deposition temperature: 120°C, sputtering deposition time: 10 min, and deposition thickness: 50 um.

In S5, an Al film layer is deposited on the Fe₃O₄ magnetic material film layer to obtain a glass element. Parameters for magnetron sputtering are as follows: Al target thickness: 10 mm, magnetic field intensity: 200 Gs, Al target power: 9 Kw, sputtering pressure: 1.5 Pa, Ar: 250 mL/min, deposition temperature: 100°C, sputtering deposition time: 20 min, and deposition thickness: 0.2 um.

In S6, the glass element obtained in S5 is cut by using a carbon dioxide laser cutting machine to obtain glass strips with a width of 0.1 mm and a length of 600 mm.

In S7, the glass strips are ultrasonically cleaned to obtain optical elements.

In S8, a plurality of optical elements are placed in parallel with reflecting surfaces facing a same direction, the optical elements are placed and tightly clamped in a special fixture, and then the optical elements are polished by using a double-sided polishing disc to obtain an optical element group.

In S9, two optical element groups are obtained through S1 to S8, the two optical element groups are stacked with the reflecting surfaces of the two optical element groups being perpendicular to each other, and the two optical element groups are bonded by using a high-transmittance adhesive to obtain the microchannel matrix optical waveguide plate. The high-transmittance adhesive includes the following raw material components in parts by weight: 70 parts of aliphatic polyurethane acrylate, 15 parts of acrylate monomer, 8 parts of isoborneol acrylate, 1 part of a photoinitiator, 0.5 parts of a leveling agent, and 1 part of a defoaming agent.

Preferably, in S1, a method for preparing the glass substrate includes the following steps:
In step 1, proportioning is performed: a glass raw material is prepared by using the following components: 70% of silica sand, 20% of kaolin, 10% of calcite and 1% of dolomite, and the glass raw material is put into a grinder for grinding till the particle size is 800-mesh.
In step 2, melting is performed: the glass raw material obtained through the grinding in step 1 is put into a tank furnace filled with nitrogen gas and hydrogen gas for melting at a melting temperature of 1,800°C to obtain molten glass.
In step 3, formation is performed: after the molten glass obtained through the melting in step 2 is cooled to 1,000°C or less, the molten glass is fed into a tin bath filled with inert gas, and standing is performed for cooling for 3 h to obtain a flat glass belt.
In step 4, annealing is performed: the glass belt obtained in step 3 is moved into an annealing furnace for annealing at an annealing temperature of 750°C.

### Embodiment 2

This embodiment provides a microchannel matrix optical waveguide plate. The microchannel matrix optical waveguide plate is formed by stacking two optical element groups perpendicularly. Each of the optical element groups is composed of a plurality of parallel-arranged optical elements 1. Each of the optical elements 1 includes a glass substrate 2. The glass substrate 2 is divided into an air surface and a reflecting surface. A first metal film layer 3, a magnetic material film layer 4 and a second metal film layer 5 are sequentially arranged on the air surface.

A method for fabricating the microchannel matrix optical waveguide plate includes the following steps:
In S1, a glass substrate is ultrasonically cleaned with acetone for 10 min, then is cleaned with ethanol for 5 min, blow-dried with nitrogen gas, and then put into a magnetron sputtering coating machine.
In S2, a working chamber of the coating machine is vacuumized to achieve a vacuum degree of 5*10⁻³ Pa, and temperature is increased to 150°C.
In S3, an Ag film layer is deposited on an air surface of the glass substrate. Parameters for magnetron sputtering deposition are as follows: Ag target thickness: 10 mm, magnetic field intensity: 50 Gs, Ag target power: 150 W, sputtering pressure: 1.5 Pa, Ar: 100 mL/min, deposition temperature: 100°C, sputtering deposition time: 5 min, and deposition thickness: 0.05 um.
In S4, an aluminum-nickel-cobalt alloy magnetic material film layer is deposited on the Ag film layer. Parameters for magnetron sputtering are as follows: aluminum-nickel-cobalt alloy target thickness: 3 mm, magnetic field intensity: 900 Gs, magnetic target power: 5 Kw, sputtering pressure: 2.5 Pa, Ar: 400 mL/min, deposition temperature: 100°C, sputtering deposition time: 20 min, and deposition thickness: 0.1 um.
In S5, an Ag film layer is deposited on the aluminum-nickel-cobalt alloy magnetic material film layer to obtain a glass element. Parameters for magnetron sputtering are as follows: Al target thickness: 10 mm, magnetic field intensity: 100 Gs, Ag target power: 9 Kw, sputtering pressure: 0.5 Pa, Ar: 100 mL/min, deposition temperature: 120°C, sputtering deposition time: 10 min, and deposition thickness: 0.05 um.
In S6, the glass element obtained in S5 is cut by using a carbon dioxide laser cutting machine to obtain glass strips with a width of 0.3 mm and a length of 100 mm.
In S7, the glass strips are ultrasonically cleaned to obtain optical elements.
In S8, a plurality of optical elements are placed in parallel with reflecting surfaces facing a same direction, the optical elements are placed and tightly clamped in a special fixture, and then the optical elements are polished by using a double-sided polishing disc to obtain an optical element group.
In S9, two optical element groups are obtained through S1 to S8, the two optical element groups are stacked with the reflecting surfaces of the two optical element groups being perpendicular to each other, and the two optical element groups are bonded by using a high-transmittance adhesive to obtain the microchannel matrix optical waveguide plate. The high-transmittance adhesive includes the following raw material components in parts by weight: 60 parts of aliphatic polyurethane acrylate, 25 parts of acrylate monomer, 8 parts of isoborneol acrylate, 10 parts of a photoinitiator, 0.01 parts of a leveling agent, and 0.1 parts of a defoaming agent.

Preferably, in S1, a method for preparing the glass substrate includes the following steps:
In step 1, proportioning is performed: a glass raw material is prepared by using the following components: 70%-85% of silica sand, 10%-20% of kaolin, 5%-10% of calcite and 1%-5% of dolomite, and the glass raw material is put into a grinder for grinding till the particle size is 600-mesh to 800-mesh.
In step 2, melting is performed: the glass raw material obtained through the grinding in step 1 is put into a tank furnace filled with nitrogen gas and hydrogen gas for melting at a melting temperature of 1,200-1,800°C to obtain molten glass.
In step 3, formation is performed: after the molten glass obtained through the melting in step 2 is cooled to 1,000°C or less, the molten glass is fed into a tin bath filled with inert gas, and standing is performed for cooling for 1-3 h to obtain a flat glass belt.
In step 4, annealing is performed: the glass belt obtained in step 3 is moved into an annealing furnace for annealing at an annealing temperature within a range of 550-750°C.

### Embodiment 3

This embodiment provides a microchannel matrix optical waveguide plate. The microchannel matrix optical waveguide plate is formed by stacking two optical element groups perpendicularly. Each of the optical element groups is composed of a plurality of parallel-arranged optical elements. Each of the optical elements includes a glass substrate. The glass substrate is divided into an air surface and a reflecting surface. A first metal film layer, a magnetic material film layer and a second metal film layer are sequentially arranged on the air surface.

A method for fabricating the microchannel matrix optical waveguide plate includes the following steps:
In S1, a glass substrate is ultrasonically cleaned with acetone for 5 min, then is cleaned with ethanol for 10 min, blow-dried with nitrogen gas, and then put into a magnetron sputtering coating machine.
In S2, a working chamber of the coating machine is vacuumized to achieve a vacuum degree of 2.0*10⁻³ Pa, and temperature is increased to 120°C.
In S3, a Ti film layer is deposited on an air surface of the glass substrate. Parameters for magnetron sputtering deposition are as follows: Ti target thickness: 8 mm, magnetic field intensity: 68 Gs, Ti target power: 120 W, sputtering pressure: 1.1 Pa, Ar: 180 mL/min, deposition temperature: 125°C, sputtering deposition time: 8 min, and deposition thickness: 0.15 um.
In S4, a neodymium-iron-boron alloy magnetic material film layer is deposited on the Ti film layer. Parameters for magnetron sputtering are as follows: neodymium-iron-boron alloy target thickness: 2 mm, magnetic field intensity: 755 Gs, magnetic target power: 3.5 Kw, sputtering pressure: 2 Pa, Ar: 240 mL/min, deposition temperature: 108°C, sputtering deposition time: 15 min, and deposition thickness: 18 um.
In S5, a Cr film layer is deposited on the neodymium-iron-boron alloy magnetic material film layer to obtain a glass element. Parameters for magnetron sputtering are as follows: Cr target thickness: 8 mm, magnetic field intensity: 140 Gs, Cr target power: 7 Kw, sputtering pressure: 1 Pa, Ar: 150 mL/min, deposition temperature: 110°C, sputtering deposition time: 10 min, and deposition thickness: 0.01 um.
In S6, the glass element obtained in S5 is cut by using a carbon dioxide laser cutting machine to obtain glass strips with a width of 0.1 mm and a length of 600 mm.
In S7, the glass strips are ultrasonically cleaned to obtain optical elements.
In S8, a plurality of optical elements are placed in parallel with reflecting surfaces facing a same direction, the optical elements are placed and tightly clamped in a special fixture, and then the optical elements are polished by using a double-sided polishing disc to obtain an optical element group.
In S9, two optical element groups are obtained through S1 to S8, the two optical element groups are stacked with the reflecting surfaces of the two optical element groups being perpendicular to each other, and the two optical element groups are bonded by using a high-transmittance adhesive to obtain the microchannel matrix optical waveguide plate. The high-transmittance adhesive includes the following raw material components in parts by weight: 75 parts of aliphatic polyurethane acrylate, 20 parts of acrylate monomer, 5 parts of isoborneol acrylate, 5 parts of a photoinitiator, 0.03 parts of a leveling agent, and 0.8 parts of a defoaming agent.

In S1, a method for preparing the glass substrate includes the following steps:
In step 1, proportioning is performed: a glass raw material is prepared by using the following components: 75% of silica sand, 12% of kaolin, 8% of calcite and 2% of dolomite, and the glass raw material is put into a grinder for grinding till the particle size is 680-mesh.
In step 2, melting is performed: the glass raw material obtained through the grinding in step 1 is put into a tank furnace filled with nitrogen gas and hydrogen gas for melting at a melting temperature of 1,600°C to obtain molten glass.
In step 3, formation is performed: after the molten glass obtained through the melting in step 2 is cooled to 1,000°C or less, the molten glass is fed into a tin bath filled with inert gas, and standing is performed for cooling for 2 h to obtain a flat glass belt.
In step 4, annealing is performed: the glass belt obtained in step 3 is moved into an annealing furnace for annealing at an annealing temperature of 650°C.

### Embodiment 4

This embodiment provides a microchannel matrix optical waveguide plate. The microchannel matrix optical waveguide plate is formed by stacking two optical element groups perpendicularly. Each of the optical element groups is composed of a plurality of parallel-arranged optical elements. Each of the optical elements includes a glass substrate. The glass substrate is divided into an air surface and a reflecting surface. A first metal film layer, a magnetic material film layer and a second metal film layer are sequentially arranged on the air surface.

A method for fabricating the microchannel matrix optical waveguide plate includes the following steps:
In S1, a glass substrate is ultrasonically cleaned with acetone for 8 min, then is cleaned with ethanol for 6 min, blow-dried with nitrogen gas, and then put into a magnetron sputtering coating machine.
In S2, a working chamber of the coating machine is vacuumized to achieve a vacuum degree of 2 *10⁻³ Pa, and temperature is increased to 120°C.
In S3, a Cr film layer is deposited on an air surface of the glass substrate. Parameters for magnetron sputtering deposition are as follows: Cr target thickness: 8 mm, magnetic field intensity: 85 Gs, Cr target power: 135 W, sputtering pressure: 1.2 Pa, Ar: 220 mL/min, deposition temperature: 140°C, sputtering deposition time: 8 min, and deposition thickness: 0.15 um.
In S4, an iron-chromium-cobalt magnetic material film layer is deposited on the Cr film layer. Parameters for magnetron sputtering are as follows: iron-chromium-cobalt alloy target thickness: 2.2 mm, magnetic field intensity: 752 Gs, magnetic target power: 3.4 Kw, sputtering pressure: 2.1 Pa, Ar: 285 mL/min, deposition temperature: 110°C, sputtering deposition time: 12 min, and deposition thickness: 35 um.
In S5, a Cr film layer is deposited on the iron-chromium-cobalt magnetic material film layer to obtain a glass element. Parameters for magnetron sputtering are as follows: Cr target thickness: 6 mm, magnetic field intensity: 170 Gs, Cr target power: 8 Kw, sputtering pressure: 1 Pa, Ar: 180 mL/min, deposition temperature: 100°C, sputtering deposition time: 20 min, and deposition thickness: 0.085 um.
In S6, the glass element obtained in S5 is cut by using a carbon dioxide laser cutting machine to obtain glass strips with a width of 0.25 mm and a length of 450 mm.
In S7, the glass strips are ultrasonically cleaned to obtain optical elements.
In S8, a plurality of optical elements are placed in parallel with reflecting surfaces facing a same direction, the optical elements are placed and tightly clamped in a special fixture, and then the optical elements are polished by using a double-sided polishing disc to obtain an optical element group.
In S9, two optical element groups are obtained through S1 to S8, the two optical element groups are stacked with the reflecting surfaces of the two optical element groups being perpendicular to each other, and the two optical element groups are bonded by using a high-transmittance adhesive to obtain the microchannel matrix optical waveguide plate. The high-transmittance adhesive includes the following raw material components in parts by weight: 68 parts of aliphatic polyurethane acrylate, 22 parts of acrylate monomer, 6 parts of isoborneol acrylate, 7 parts of a photoinitiator, 0.25 parts of a leveling agent, and 0.85 parts of a defoaming agent.

Preferably, in S1, a method for preparing the glass substrate includes the following steps:
In step 1, proportioning is performed: a glass raw material is prepared by using the following components: 75% of silica sand, 10% of kaolin, 10% of calcite and 5% of dolomite, and the glass raw material is put into a grinder for grinding till the particle size is 600-mesh.
In step 2, melting is performed: the glass raw material obtained through the grinding in step 1 is put into a tank furnace filled with nitrogen gas and hydrogen gas for melting at a melting temperature of 1,200°C to obtain molten glass.
In step 3, formation is performed: after the molten glass obtained through the melting in step 2 is cooled to 1,000°C or less, the molten glass is fed into a tin bath filled with inert gas, and standing is performed for cooling for 1 h to obtain a flat glass belt.
In step 4, annealing is performed: the glass belt obtained in step 3 is moved into an annealing furnace for annealing at an annealing temperature within a range of 550-750°C.

### Embodiment 5

This embodiment provides a microchannel matrix optical waveguide plate. The microchannel matrix optical waveguide plate is formed by stacking two optical element groups perpendicularly. Each of the optical element groups is composed of a plurality of parallel-arranged optical elements. Each of the optical elements includes a glass substrate. The glass substrate is divided into an air surface and a reflecting surface. A first metal film layer, a magnetic material film layer and a second metal film layer are sequentially arranged on the air surface.

A method for fabricating the microchannel matrix optical waveguide plate includes the following steps:
In S1, a glass substrate is ultrasonically cleaned with acetone for 5 min, then is cleaned with ethanol for 10 min, blow-dried with nitrogen gas, and then put into a magnetron sputtering coating machine.
In S2, a working chamber of the coating machine is vacuumized to achieve a vacuum degree of 5*10⁻³ Pa, and temperature is increased to 100°C.
In S3, an Sn film layer is deposited on an air surface of the glass substrate. Parameters for magnetron sputtering deposition are as follows: Sn target thickness: 8 mm, magnetic field intensity: 65 Gs, Sn target power: 90 W, sputtering pressure: 0.6 Pa, Ar: 146 mL/min, deposition temperature: 121°C, sputtering deposition time: 8 min, and deposition thickness: 0.2 um.
In S4, a samarium-cobalt magnetic material film layer is deposited on the Sn film layer. Parameters for magnetron sputtering are as follows: samarium-cobalt alloy target thickness: 2.8 mm, magnetic field intensity: 720 Gs, magnetic target power: 3 Kw, sputtering pressure: 1.8 Pa, Ar: 280 mL/min, deposition temperature: 100°C, sputtering deposition time: 12 min, and deposition thickness: 18 um.
In S5, an Sn film layer is deposited on the samarium-cobalt magnetic material film layer to obtain a glass element. Parameters for magnetron sputtering are as follows: Sn target thickness: 8 mm, magnetic field intensity: 200 Gs, Cr[sy1] target power: 3 Kw, sputtering pressure: 0.5 Pa, Ar: 100 mL/min, deposition temperature: 112°C, sputtering deposition time: 16 min, and deposition thickness: 0.1 um.
In S6, the glass element obtained in S5 is cut by using a carbon dioxide laser cutting machine to obtain glass strips with a width of 0.1 mm and a length of 300 mm.
In S7, the glass strips are ultrasonically cleaned to obtain optical elements.
In S8, a plurality of optical elements are placed in parallel with reflecting surfaces facing a same direction, the optical elements are placed and tightly clamped in a special fixture, and then the optical elements are polished by using a double-sided polishing disc to obtain an optical element group.
In S9, two optical element groups are obtained through S1 to S8, the two optical element groups are stacked with the reflecting surfaces of the two optical element groups being perpendicular to each other, and the two optical element groups are bonded by using a high-transmittance adhesive to obtain the microchannel matrix optical waveguide plate. The high-transmittance adhesive includes the following raw material components in parts by weight: 72 parts of aliphatic polyurethane acrylate, 18 parts of acrylate monomer, 6 parts of isoborneol acrylate, 3 parts of a photoinitiator, 0.2 parts of a leveling agent, and 0.6 parts of a defoaming agent.

Preferably, in S1, a method for preparing the glass substrate includes the following steps:
In step 1, proportioning is performed: a glass raw material is prepared by using the following components: 75% of silica sand, 15% of kaolin, 8% of calcite and 3% of dolomite, and the glass raw material is put into a grinder for grinding till the particle size is 700-mesh.
In step 2, melting is performed: the glass raw material obtained through the grinding in step 1 is put into a tank furnace filled with nitrogen gas and hydrogen gas for melting at a melting temperature of 1,500°C to obtain molten glass.
In step 3, formation is performed: after the molten glass obtained through the melting in step 2 is cooled to 1,000°C or less, the molten glass is fed into a tin bath filled with inert gas, and standing is performed for cooling for 1.5 h to obtain a flat glass belt.
In step 4, annealing is performed: the glass belt obtained in step 3 is moved into an annealing furnace for annealing at an annealing temperature of 650°C.

Although the present invention has been described with reference to the preferred embodiments, various improvements may be made and components may be replaced with equivalents without departing from the scope of the present invention. Especially, as long as there is no structural conflict, the various technical features mentioned in each embodiment may be combined in any way. The present invention is not limited to the specific embodiments disclosed herein, but includes all technical solutions falling within the scope of the claims.

## Claims

1. A microchannel matrix optical waveguide plate, being formed by stacking two optical element groups perpendicularly, each of the optical element groups being composed of a plurality of parallel-arranged optical elements, each of the optical elements comprising a glass substrate, the glass substrate being divided into an air surface and a reflecting surface, a first metal film layer, a magnetic material film layer and a second metal film layer being sequentially arranged on the air surface;
a method for fabricating the microchannel matrix optical waveguide plate comprising:
S1: ultrasonically cleaning the glass substrate with acetone for 5-10 min, then cleaning the glass substrate with ethanol for 5-10 min, blow-drying the glass substrate with nitrogen gas, and then putting the glass substrate into a magnetron sputtering coating machine;
S2: vacuumizing a working chamber of the coating machine to achieve a vacuum degree of 1.0*10⁻³-5*10⁻³ Pa, and increasing temperature to 100-150°C;
S3: performing magnetron sputtering deposition on the air surface of the glass substrate by using a first metal target to obtain the first metal film layer with a deposition thickness of 0.05-0.2 um;
S4: performing magnetron sputtering deposition on the first metal film layer by using a magnetic target to obtain the magnetic material film layer with a deposition thickness of 0.1-50 um;
S5: performing magnetron sputtering deposition on the magnetic material film layer by using a second metal target to obtain a second metal film layer with a deposition thickness of 0.05-0.2 um to obtain a glass element;
S6: cutting the glass element obtained in S5 by using a carbon dioxide laser cutting machine to obtain glass strips with a width of 0.1-0.3 mm and a length of 100-600 mm;
S7: ultrasonically cleaning the glass strips to obtain the optical elements;
S8: placing a plurality of optical elements in parallel with reflecting surfaces facing a same direction, placing and tightly clamping the optical elements in a special fixture, and then polishing the optical elements by using a double-sided polishing disc to obtain an optical element group; and
S9: obtaining two optical element groups through S1 to S8, stacking the two optical element groups with the reflecting surfaces of the two optical element groups being perpendicular to each other, and bonding the two optical element groups by using a high-transmittance adhesive to obtain the microchannel matrix optical waveguide plate.

2. The microchannel matrix optical waveguide plate according to claim 1, wherein in S1, a method for fabricating the glass substrate comprises:
step 1: proportioning: preparing a glass raw material by using the following components: 70%-85% of silica sand, 10%-20% of kaolin, 5%-10% of calcite and 1%-5% of dolomite, and putting the glass raw material into a grinder for grinding till a particle size is 600-mesh to 800-mesh;
step 2: melting: putting the glass raw material obtained through the grinding in step 1 into a tank furnace filled with nitrogen gas and hydrogen gas for melting at a melting temperature of 1,200-1,800°C to obtain molten glass;
step 3: formation: after the molten glass obtained through the melting in step 2 is cooled to 1,000°C or less, feeding the molten glass into a tin bath filled with inert gas, and standing for cooling for 1-3 h to obtain a flat glass belt; and
step 4: annealing: moving the glass belt obtained in step 3 into an annealing furnace for annealing at an annealing temperature within a range of 550-750°C.

3. The microchannel matrix optical waveguide plate according to claim 1, wherein in S3, parameters for the magnetron sputtering deposition of the first metal film layer are as follows: Al target thickness: 5-10 mm, magnetic field intensity: 50-100 Gs, Al target power: 80-150 W, sputtering pressure: 0.5-1.5 Pa, Ar: 100-250 mL/min, deposition temperature: 100-150°C, and sputtering deposition time: 5-10 min.

4. The microchannel matrix optical waveguide plate according to claim 1, wherein in S4, parameters for the magnetron sputtering deposition of the magnetic material film layer are as follows: magnetic target thickness: 2-3 mm, magnetic field intensity: 600-900 Gs, magnetic target power: 2-5 Kw, sputtering pressure: 1.5-2.5 Pa, Ar: 200-400 mL/min, deposition temperature: 100-120°C, and sputtering deposition time: 10-20 min.

5. The microchannel matrix optical waveguide plate according to claim 1, wherein in S4, the magnetic target is one of ferrite, aluminum-nickel-cobalt alloy, samarium-cobalt alloy, neodymium-iron-boron alloy, and iron-chromium-cobalt alloy.

6. The microchannel matrix optical waveguide plate according to claim 1, wherein in S5, parameters for the magnetron sputtering deposition of the second metal film layer are as follows: Al target thickness: 5-10 mm, magnetic field intensity: 100-200 Gs, Al target power: 3-9 Kw, sputtering pressure: 0.5-1.5 Pa, Ar: 100-250 mL/min, deposition temperature: 100-120°C, and sputtering deposition time: 10-20 min.

7. The microchannel matrix optical waveguide plate according to claim 1, wherein the first metal target in S3 and the second metal target in S5 are one of Ti, Sn, Cr, Al, or Ag.

8. The microchannel matrix optical waveguide plate according to claim 1, wherein in S9, the high-transmittance adhesive comprises the following raw material components in parts by weight: 60-80 parts of aliphatic polyurethane acrylate, 15-25 parts of acrylate monomer, 0.1-0.5 parts of hexanediol, 2-8 parts of isoborneol acrylate, 1-10 parts of a photoinitiator, 0.01-0.5 parts of a leveling agent, and 0.1-1 part of a defoaming agent.
